# EUROPÄISCHE PATENTSCHRIFT

(11) **EP 1 086 495 B1**
(45) Veröffentlichungstag und Bekanntmachung des Hinweises auf die Patenterteilung: **14.03.2012**
(21) Anmeldenummer: 99934464.1
(22) Anmeldetag: 10.05.1999
(51) Int. Cl.: H01L 29/739, H01L 21/331, H01L 29/868, H01L 21/329, H01L 29/74, H01L 21/332, H01L 29/06, H01L 21/20, H01L 29/40

(54) **HOCHSPANNUNGS-HALBLEITER-BAUELEMENT UND VERFAHREN ZU SEINER HERSTELLUNG SOWIE VERWENDUNG DES HALBLEITER-BAUELEMENTS**
HIGH-VOLTAGE SEMICONDUCTOR COMPONENT, METHOD FOR THE PRODUCTION AND USE THEREOF
COMPOSANT A SEMI-CONDUCTEUR HAUTE TENSION, SON PROCEDE DE PRODUCTION ET SON UTILISATION

(30) Priorität: 11.05.1998 DE 19820956
(43) Veröffentlichungstag der Anmeldung: 28.03.2001
(73) Patentinhaber: Infineon Technologies AG, 85579 Neubiberg (DE)
(72) Erfinder: SILBER, Dieter, D-63179 Obertshausen (DE); WONDRAK, Wolfgang, D-60385 Frankfurt am Main (DE); PLIKAT, Robert, D-72800 Eningen (DE)
(74) Vertreter: Dziewior, Joachim
(86) Internationale Anmeldenummer: PCT/DE1999/001410
(87) Internationale Veröffentlichungsnummer: WO 1999/059208

(56) Entgegenhaltungen:
- EP-A- 0 519 741
- DE-A- 19 533 956
- US-A- 5 378 912
- US-A- 5 640 040

## Beschreibung

Die Erfindung betrifft ein Halbleiter-Bauelement mit mindestens einem lateralen Bauelement zur Aufnahme einer lateralen elektrischen Feldstärke sowie verfahren zur Herstellung und eine Verwerdung gemäß den Oberbegriffen der unabhängigen Ansprüche.

In der DE-Al-42 33 773 ist Bauelement in sorgen. SOI-Technologie (Semiconductor-On-Insulator) offenbart, welches eine erhöhte Durchbruchspannung aufweist. Das Halbleiter-Bauelement weist ein laterales Bauelement in einem Halbleiterkörper mit einem Substrat auf, wobei an das Substrat angrenzend eine dielektrische Zone angeordnet ist, in der elektrisch leitfähige Bereiche eingebettet sind. Die Anordnung erfordert eine Justierung der vergrabenen Struktur bezüglich des lateralen Bauelements, was technologisch aufwendig ist.

Aus der DE 19533956A1 ist eine Leistungshalbleitervorrichtung bekannt, die aus einem vergrabenen Siliciumdioxydfilm mit einem unebenen Oberflächenteil auf seiner Oberfläche gebildet ist und eine n-Typ-Silicium-Aktivschicht von niedriger Fremdstoffkonzentration aufweist, die auf dem vergrabenen Siliciumdioxydfilm vorgesehen ist. Eine n-Typ-Emitterschicht und eine p-Typ-Emitterschicht sind selektiv auf der Oberfläche der n-Typ-Silicium-Aktivschicht ausgebildet. Eine Kathodenelektrode und eine Anodenelektrode sind jeweils auf der n-Typ-Emitterschicht und der p-Typ-Emitterschicht vorgesehen. Mit diester Struktur kann eine Leistungshalbleitervorrichtung von hoher Stehspannung realisiert werden.

Weiterhin sind sowohl laterale als auch vertikale Bauelemente vorgeschlagen worden, welche an der Oberfläche Strukturen aufweisen, die zur Reduzierung der Oberflächenfeldstärke vorgesehen sind, um die Durchbruchspannung zu erhöhen. Derartige Feldplatten oder Feldringe führen jedoch ebenfalls zu einem hohen technologischen Aufwand bei der Herstellung derartiger Bauelemente.

Aufgabe der Erfindung ist es, ein Halbleiter-Bauelement und ein Verfahren zu seiner Herstellung anzugeben, welches Bauelemente gemäß der vorausgehend beschriebenen Art verbessert und insbesondere höhere Durchbruchspannungen ermöglicht.

Die Aufgabe wird durch die Merkmale der unabhängigen Ansprüche gelöst. Weiterführende und vorteilhafte Ausgestaltungen sind den weiteren Ansprüchen und der Beschreibung zu entnehmen.

In einer bevorzugten Ausführung ist das Halbleiter-Bauelement ein laterales Bauelemente mit einer an ein Substrat angrenzenden dielektrischen Zone und zwischen dielektrischer Zone und Halbleiterkörper zumindest unter einem Teilbereich des lateralen Bauelements angeordneter lateraler, dreidimensionaler Struktur, die mit der dielektrischen Zone in unmittelbarer Verbindung steht.

In einer günstigen Ausführung der Erfindung weist die dreidimensionale Struktur Inseln auf, welche durch vertikale Vertiefungen voneinander getrennt sind, wobei die elektrische Leitfähigkeit in den Vertiefungen geringer ist als in den Inseln.

In einer weiteren günstigen Ausführung der Erfindung weist die dreidimensionale Struktur Stege auf, welche durch vertikale Vertiefungen voneinander getrennt sind, wobei die elektrische Leitfähigkeit in den Vertiefungen geringer ist als die in den Stegen.

Günstig ist, im Halbleiterkörper zumindest bereichsweise lateral einen Halbleiter aus einem weiteren Material, insbesondere polykristallines Silizium, anzuordnen, welcher an die dielektrische Zone grenzt.

Günstig ist, zwischen Substrat und dielektrischer Zone zumindest bereichsweise eine laterale Halbleiterschicht anzuordnen. Eine weitere günstige Anordnung ist, zwischen Substrat und dielektrischer Zone zumindest bereichsweise eine laterale Isolatorschicht anzuordnen.

Vorteilhaft ist, bei einem lateralen Bauelement zumindest bereichsweise die Breite der Vertiefungen in einer gedachten Schnittebene senkrecht durch das laterale Bauelement kleiner als 10% der lateralen Driftstrecke des lateralen Bauelements vorzusehen.

Günstig ist, im Bauelement zumindest bereichsweise die Breite der Zwischenräume zwischen benachbarten Vertiefungen in einer gedachten Schnittebene senkrecht durch das laterale Bauelement in etwa kleiner als 30% der lateralen Driftstrecke ist.

Die Durchbruchspannung läßt sich weiter erhöhen, indem unterhalb unterschiedlicher funktioneller Bereiche des Bauelements unterschiedliche Dichten der Vertiefungen vorgesehen sind.

Zweckmäßigerweise ist zumindest bereichsweise die Tiefe der vertiefungen größer als deren Breite. Günstigerweise ist zumindest bereichsweise die Breite der Vertiefungen geringer als die Dicke der dielektrischen Zone. Der besondere Vorteig ist, daß bei vergleichbarer Sperrspannung die Dicke der dielektrischen Zone eines erfindungsgemäßen Bauelements geringe sein kann als bei einem herkömmlichen Bauelement. Die Wärmeableitung im erfindungsgemäßen Bauelement ist verbessert und gleichzeitig ist das Verhalten des erfindungsgemäßen Bauelements beim Auftreten kurzzeitiger hoher elektrischer Die bereichsweise die Breite der Vertiefungen geringer als die Breite der zwischen den Vertiefungen angeordneten

Bereiche des Halbleiterkörpers vorzusehen.

Der Halbleiterkörper zwischen den Vertiefungen stellt durch die Vertiefungen unterbrochene Zonen dar, in denen sich Elektronen- oder Löcherkanäle bilden können, die in ihrer elektrostatischen Wirkung bereits gering entfernt von dem Bereich wie eine kontinuierliche Ladungsverteilung scheinen, so daß Feldgradienten und/oder Raumladungszonenkrümmung verringert werden, was zu einer Erhöhung der Durchbruchspannung führt.

Eine vorteilhafte Anordnung ist, daß die Erfindung bei einem Halbleiter-Bauelement mit einer Randstruktur zum Reduzieren der Oberflächenfeldstärke des Bauelements vorzusehen, wobei die Randstruktur an oder in einer äußeren Oberfläche des Halbleiterkörpers zumindest benachbart zum Wirkungsbereich einer oberflächennahen Raumladungszone an einem Sperrkontakt in dem Halbleiterkörper angeordnet ist, wobei der Halbleiterkörper zumindest bereichsweise an der Oberfläche eine laterale, dreidimensionale Struktur mit vertikalen Vertiefungen aufweist, innerhalb derer die elektrische Leitfähigkeit geringer ist als die des Halbleiterkörpers.

Der Vorteil der lateralen Struktur besteht darin, daß eine Feldstärke im Halbleiterkörper oder an der Oberfläche des Halbleiterkörpers teilweise abgeschirmt wird, so daß das Sperrverhalten des Bauelements verbessert wird. Die erfindungsgemäße Struktur ist insbesondere für Bauelemente auf SOI-Basis (Silicon-On-Insulator) geeignet und auch für vertikale oder laterale Bauelemente, bei denen feldstärkereduzierende Strukturen an der Oberfläche zur Reduzierung einer Oberflächenfeldstärke und/oder der Krümmung von Raumladungszonen vorgesehen sind. Besonders günstig ist die Anwendung in Verbindung mit Feldplatten oder feldringartigen Strukturen an der Oberfläche.

Teil der Erfindung ist auch Verwendung eines Bauelements mit lateraler dreidimensionaler Struktur in einer Treiberschaltung für leistungselektronische Umrichtersysteme. Die Spannungsfestigkeit kann leicht auf über 500V angehoben werden, so daß ein Einsatz für Netze mit höherer Spannung, insbesondere für 220 V-Netze oder 380 V-Drehstromnetze möglich ist.

Im folgenden sind die Merkmale, soweit sie für die Erfindung wesentlich sind, eingehend erläutert und anhand von Figuren näher beschrieben. Es zeigen
- Fig. 1: Prinzipdarstellung eines erfindungsgemäßen Bauelements,
- Fig. 2: Kennlinien von Sperrströmen eines Bauelements mit und ohne erfindungsgemäßer Struktur,
- Fig. 3: Prinzipdarstellung eines erfindungsgemäßen Bauelements mit Feldreduzierungsstruktur
- Fig. 4: Kennlinien von Sperrströmen eines Bauelements mit (b) und ohne (a) erfindungsgemäßer Struktur.

Im folgenden Ausführungsbeispiel ist die Erfindung anhand eines Diode-Bauelements beschrieben. Es versteht sich jedoch, daß die erfindungsgemäße Lösung sich zumindest für mikroelektronische laterale Bauelemente eignet, bei denen sogen. Back-Gate-Probleme auftreten, wie Dioden oder Transistoren, aber besonders auch Bauelemente des IGBT-Typs verschiedener Ausführungsarten von IGBTs und/oder Bauelemente des Thyristor-Typs verschiedener Ausführungsarten von Thyristor-Bauelementen, bei denen Back-Gate-Probleme besonders ins Gewicht fallen.

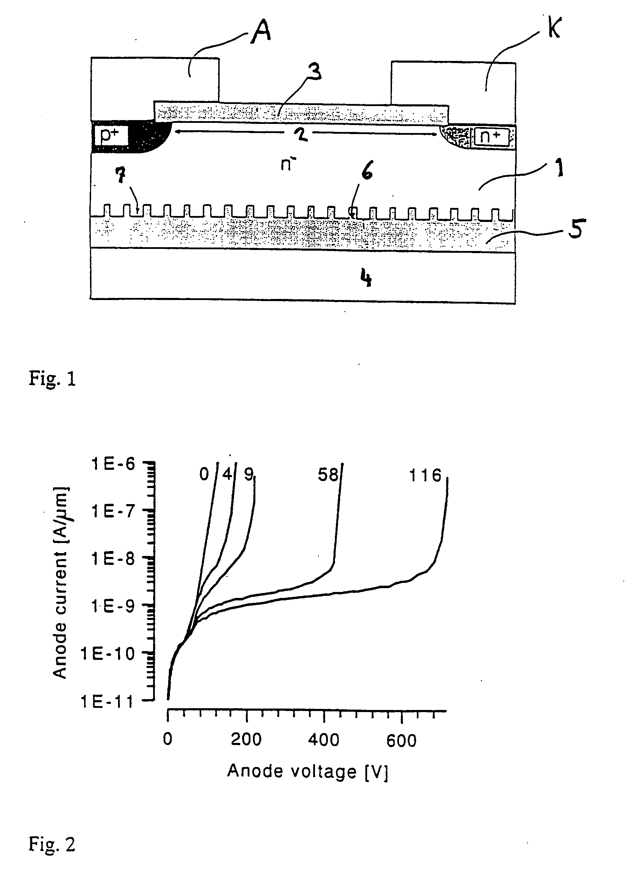

In Fig. 1 ist eine erfindungsgemäße Lösung anhand eines Diode-Bauelements dargestellt. In einem Halbleiterkörper 1 ist ein laterales Bauelement mit Anodenanschluß A und Kathodenanschluß K als Hauptelektroden an der äußeren Oberfläche des Halbleiterkörpers 1 gezeigt. Unterhalb des Anodenanschlusses A ist ein p⁺-dotierter Bereich, unterhalb des Kathodenanschlusses K ist ein n⁺-dotierter Bereich jeweils im oberflächennahen Bereich angeordnet. Zwischen den Hauptelektroden befindet sich die Driftstrecke 2 des lateralen Bauelements. Diese ist mit einer Schicht, insbesondere einem Oxid 3, bedeckt. Der Halbleiterkörper 1 außerhalb der dotierten Bereiche weist eine n⁻-Dotierung auf. Zwischen Halbleiterkörper 1 und Substrat 4 ist eine Zone angeordnet, die substratseitig eine dielektrische Zone 5 aufweist, an die eine laterale dreidimensionale Struktur angrenzt, wobei Vertiefungen 6 in den Halbleiterkörper hineinragen. Die elektrische Leitfähigkeit innerhalb der Vertiefungen 6 ist geringer als die der Zwischenräume 7 zwischen dem Vertiefungen 6, wobei die Zwischenräume 7 Bereiche des Halbleiterkörpers 1 darstellen. Der Übersichtlichkeit wegen ist nur jeweils eine Vertiefung der Vertiefungen 6 und ein Zwischenraum der Zwischenräume 7 mit einem Bezugszeichen versehen.

Die Vertiefungen 6 sind mit einem dielektrischen oder semiisolierenden Material gefüllt, das eine geringere elektrische Leitfähigkeit aufweist als das Material in den Zwischenräumen 7, vorzugsweise können die Vertiefungen mit demselben dielektrischen Material gefüllt sein, welches die angrenzende dielektrische Zone 5 bildet. Ebenso können die Zwischenräume 7 aus demselben Halbleitermaterial gebildet sein wie der Halbleiterkörper 1. Es ist jedoch auch möglich, die Vertiefungen mit einem anderen dielektrischen Material als die dielektrische Zone zu füllen, oder auch mit semüsolierendem Material.

In einer günstigen Ausführung ist zwischen dem Halbleiterkörper 1 und der dielektrischen Zone 5 ein weiteres Halbleitermaterial angeordnet, vorzugsweise eines mit größerem energetischen Bandabstand von Valenz- und Leitungsband. In einer besonders günstigen Kombination wird der Halbleiter aus Silizium und der Bereich zwischen Halbleiterkörper 1 und dielektrischer Zone 5 aus Siliziumkarbid gebildet. Eine solche Materialkombination unterstützt die vorteilhafte Wirkung der Erfindung hinsichtlich der Erhöhung der Durchbruchspannung zusätzlich.

Wird der Halbleiterkörper 1 auf einem separaten Substratwafer 4 aufgebondet, wie dies insbesondere bei sogen. SOI-Bauelementen (Silicon-On-Insulator) üblich ist, kann die laterale dreidimensionale Struktur 6, 7 sowohl im aktiven Halbleiterkörper 1 als auch im Substratwafer 4 hergestellt werden.

Erfindungsgemäß werden in die Rückseite des Halbleiterkörpers 1, welche der Vorderseite mit dem lateralen Bauelement gegenüberliegt, Vertiefungen 6 geätzt. Anschließend werden die Vertiefungen 6 mit einem Oxid, insbesondere Siliziumoxid, gefüllt, wobei eine dickere Oxidschicht schließlich die Vertiefungen 6 vollständig überdeckt. Die Schicht wird anschließend planarisiert und bildet die dielektrische Zone 5. Auf diese wird ein Substratwafer insbesondere mit dem sogen. Silizium-Direkt-Bonding-Verfahren aufgebondet.

Es ist jedoch auch möglich, nicht die dielektrische Zone 5 selbst zu planarisieren, sondern diese mit einem Halbleiter, insbesondere polykristallines Silizium, zu beschichten und erst dieses dann zu planarisieren. Dies ist von Vorteil, wenn das dielektrische Material schwer zu polieren oder zu bearbeiten ist. Das Substrat wird dann mit der planarisierten Halbleiterschicht verbunden. Es ist auch möglich, auf einen Planarisierungsschritt ganz zu verzichten. Eine weitere günstige Anordnung besteht darin, einen als Substrat 4 vorgesehenen Wafer zumindest an der zur Verbindung vorgesehenen Oberfläche zu oxidieren oder mit einem Oxid zu beschichten und dann mit der dielektrischen Zone 5 zu verbinden.

Ein weiteres erfinderisches Verfahren ist, einen als Substrat 4 vorgesehenen Wafer zu oxidieren und in das Waferoxid Gräben einzubringen, die mit Halbleitermaterial gefüllt werden, insbesondere polykristallines Silizium. Die Gräben können mit weiterem Halbleitermaterial überdeckt und planarisiert werden und anschließend mit dem Halbleiterkörper 1 verbunden werden. In diesem Fall ist eine Grenzschicht zwischen Halbleiterkörper 1 und Halbleitermaterial der lateralen dreidimensionalen Struktur vorhanden. Die Gräben im Waferoxid entsprechen den Zwischenräumen 7 und die Zwischenräume zwischen den Gräben im Waferoxid den Vertiefungen 6 im Halbleiterkörper.

Die Vertiefungen 6 der erfindungsgemäßen lateralen dreidimensionalen Struktur 6, 7 stellen im wesentlichen Unterbrechungen eines vergrabenen Kanals in Kanalabschnitte dar, die durch die Zwischenräume 7 des Halbleiterkörpers gebildet werden und ermöglichen dort einen lateralen Spannungsabfall. Auf größere Abstände wirken diese Kanalabschnitte 7 wie eine kontinuierliche Verteilung von Ladungsträgern. Eine Vertiefung 6 unterbricht einen Kanal in eine Kanalabschnitt, so daß sich an einer Seite des Zwischenraums 7 Ladungsträger ansammeln, z.B. Löcher in einem n-dotierten Halbleiterkörper 1, wenn eine laterale Spannung anliegt. Die Ladungsträger an der Seite schirmen das Gebiet vom Potential des Substrats 4 ab, und die Feldstärke, die aufgrund der unterschiedlichen elektrischen Potentiale von Halbleiterkörper 1 und Substrat 4 im Halbleiterkörper 1 entsteht, ist gering.

Falls sich Diffusionsstrom und durch das elektrische Feld induzierter Strom ausgleichen, ergibt sich der resultierende Löcherstrom zu Null. Steigt der Spannungsabfall über die Vertiefung 6 an, so wird ab einer Grenzspannung der Feldanteil des Stroms jedoch so groß, daß die Ladungsträger in Richtung Kathode in den nächsten Zwischenraum 7 fließen. Werden die Ladungsträger des Kanalabschnitts abgesaugt, breitet sich eine Raumladungszone aus, und die elektrische Feldstärke ist hoch. Ist die Breite des Zwischenraums 7 zu groß 7, kann sich eine Stoßionisation ausbreiten, die jedoch durch Verringern der Breite des Zwischenraums, d.h. Erhöhung der Zahl der Vertiefungen 6, verringert werden kann und eine Stoßionisation nur noch an der Bauelementoberfläche auftritt. Ein Potentialsprung zwischen Substrat 4 und Halbleiterkörper kann größtenteils durch die dielektrische Zone 5 aufgenommen werden, während das elektrische Potential im Halbleiterkörper 1 auch lateral ansteigt.

Die einzelnen Kanalabschnitte können bei steigender Spannung zwischen Anode und Kathode und sich ausbreitender Raumladungszone Spannung aufnehmen, so daß Feldgradienten und die Krümmung der Raumladungszone im Halbleiterkörper 1 geringer werden. Damit steigt die Sperrspannung des Bauelements.

Besonders vorteilhaft ist, wenn die Dimension der Tiefe der Vertiefungen 6 größer ist als die Breite der Vertiefungen. Günstig ist auch, die Zwischenräume 7 breiter zu wählen als die Breite der Vertiefungen 6. Eine günstige Dimensionierung für die Vertiefungen 6 und Zwischenräume 7 sind in einem lateralen Bauelement, wenn die Breite der Vertiefungen 6 in einer gedachten Schnittebene senkrecht durch das laterale Bauelement (z.B. die Bildebene in Fig. 1) höchstens 10% der lateralen Driftstrecke 2 des lateralen Bauelements ist. Vorzugsweise sind die Zwischenräume 7, d.h. der Abstand zwischen zwei unmittelbar benachbarten Vertiefungen 6 schmäler als 30% der lateralen Driftstrecke 2.

Je mehr Vertiefungen 6 und damit auch Zwischenräume 7 unterhalb des lateralen Bauelements angeordnet sind, desto stärker ist der Effekt auf die Erhöhung der Durchbruchspannung. Dies ist in Fig. 2 dargestellt. In der Figur sind Kurven dargestellt, die den Verlauf des Sperrstroms als Funktion von der angelegten Spannung zeigen. Als Variable ist die Zahl der Vertiefungen 6 unterhalb des lateralen Bauelements angegeben. Ab etwa 4 Vertiefungen 6 ist ein Effekt auf den Sperrstrom zu erkennen, der bei etwas höherer Spannung durchbricht. Bei etwa 100 Vertiefungen ist der Effekt auf den Sperrstrom stark ausgeprägt, die Durchbruchspannung ist auf über 700 V angestiegen. Günstige Breiten der Vertiefungen sind im Bereich 0,2 bis 2 µm und Tiefen von 0,5 bis 2 µm.

Günstig ist, wenn die Breite der Zwischenräume 7 größer ist als die Dicke der dielektrischen Zone 5. Ein besonderer Vorteil der lateralen dreidimensionalen Struktur 6, 7 ist, daß die dielektrische Zone 5, die in den meisten im Stand der Technik bekannten Ausführungsformen eine schlechte Wärmeleitfähigkeit besitzt, bei gleicher Sperrfähigkeit des Bauelements dünner ausgeführt werden als bei einem vergleichbaren Bauelement ohne Struktur 6, 7. Um bei einem Bauelement gemäß dem Stand der Technik eine größere Sperrfähigkeit zu erzielen, kann zwar die dielektrische Zone 5 dicker ausgeführt werden, jedoch verschlechtern sich die Eigenschaften des Bauelements wegen der verschlechterten Wärmeabfuhr aus der aktiven Zone des Bauelements. Überdies begrenzen technologische Probleme die Erzeugung sehr dicker Schichten 5, wie sie für hochsperrende Bauelemente benötigt würden. Das Problem ist bei kurzzeitig auftretenden hohen Leistungen in einem Bauelement besonders gravierend, so daß ein Bauelement gemäß der Erfindung für einen solchen Einsatz wesentlich vorteilhafter ist. Die Wärmeabfuhr kann durch ein optimale Auslegung und Abstimmung der dielektrischen Zone 5 und der Vertiefungen 6 und Zwischenräume 7, insbesondere auch durch die Wahl der Materialien für die Vertiefungen 6 und die Zwischenräume 7, optimiert werden.

Bevorzugt sind die Vertiefungen 6 so angeordnet, daß das Halbleitermaterial dazwischen zylinderförmig stehenbleibt. Eine weitere bevorzugte Anordnung ist, daß das Halbleitermaterial zwischen den Vertiefungen 6 Stege bildet.

Erfindungsgemäß erreicht man eine weitere Verbesserung der Sperrfähigkeit, indem die Vertiefungen 6 unterhalb von verschiedenen funktionalen Bereichen des Halbleiterkörpers verschieden dicht angeordnet sind. Zwar entfällt damit teilweise der Vorteil der einfacheren Prozeßtechnologie, jedoch kann die Sperrfähigkeit noch weiter gesteigert werden. Besonders günstig ist, die Dichte unter einer Hauptelektrode dichter zu wählen als unterhalb der Driftstrecke 2.

Die genaue Dimensionierung ist vom verwendeten Halbleitermaterial, den Dotierverhältnissen und dem Einsatzzweck des Bauelements abhängig. Für eine geeignete Dimensionierung von Vertiefungen 6 und Zwischenräumen 7 ist es günstig, die Breite der Vertiefungen 6 möglichst klein zu halten, so daß möglichst viele Zwischenräume 7 ausgebildet werden können, da der laterale Spannungsabfall über der Struktur 6, 7 im wesentlichen von der Anzahl der Kanalabschnitte 7 abhängt.

Die pro Zwischenraum 7 aufnehmbare Spannung nimmt mit der Tiefe der Vertiefungen 6 zu, so daß das Aspektverhältnis (Tiefe zu Breite der Vertiefungen 6) möglichst hoch gewählt werden soll. Dem entgegen steht die entsprechende Reduktion der wirksamen Bauelementdicke im Halbleiterkörper 1. Die Wirksamkeit der Vertiefungen 6 ist in Bereichen hoher Feldstärke besonders hoch, so daß eine erhöhte Dichte von Vertiefungen 6 im Bereich unterhalb eines sperrgepolten Übergangs im Halbleiterkörper zweckmäßig ist.

Da die Oxiddicke der dielektrischen Zone 5 die Höhe der elektrischen Feldstärke an der unteren Grenzschicht zum Substrat 4 bestimmt, ist es zweckmäßig, die dielektrische Zone 5 möglichst so dünn zu machen, wie ihre Durchbruchfeldstärke erlaubt. Es ist gemäß der Erfindung demnach nicht mehr notwendig, die Zone 5 deshalb dicker auszuführen, weil eine im Halbleiterkörper 1 etwaig auftretende Feldstärke erniedrigt werden müßte. Gleichzeitig führt die verringerte Dicke der Zone 5 zu der vorteilhaften verbesserten Wärmeabfuhr aus der aktiven Zone.

Bei der Dimensionierung der Zwischenräume 7 ist die Dotierungskonzentration der Driftstrecke 2 zu beachten, da in den Zwischenräumen 7, in denen die Ladungsträger der Kanalabschnitte abgesaugt werden, Stoßionisation auftreten kann, die das Sperrverhalten ungünstig beeinflußt.

In einem bevorzugten Bauelement gemäß der Erfindung ist eine günstige Dicke des Halbleiterkörpers 1 etwa 10 µm bei einer Driftstrecke 2 von etwa 150 µm und einer unterhalb der Driftstrecke 2 angeordneten Anzahl von etwa 140 Vertiefungen 6. Die Sperrspannung des Bauelements gemäß Fig. 1 ist bis über 1100 V erhöht.

Sind Zwischenräume 7 sehr schmal, greift die Feldstärke weniger stark von der Substratseite her in den Halbleiterkörper 1 ein. Dies führt zu einer erhöhten Feldstärke im Bereich eines sperrgepolten pn-Übergangs in einem Bauelement gemäß Fig. 1. Wenn verhindert werden soll, daß die elektrische Wirkung des Substrats 4 zu stark unterbunden wird, ist eine Breite der Zwischenräume 7 günstig, die mindestens so groß ist, daß ein vertikales Durchgreifen der Feldstärke vom Substrat 4 zur Oberfläche des Halbleiterkörpers 1 noch möglich ist.

Besonders günstig ist die Verwendung der lateralen Struktur 6, 7 in den verschiedenen Varianten von Bauelementen des IGBT-Typs und auch in den verschiedenen Varianten von Bauelementen des Thyristor-Typs.

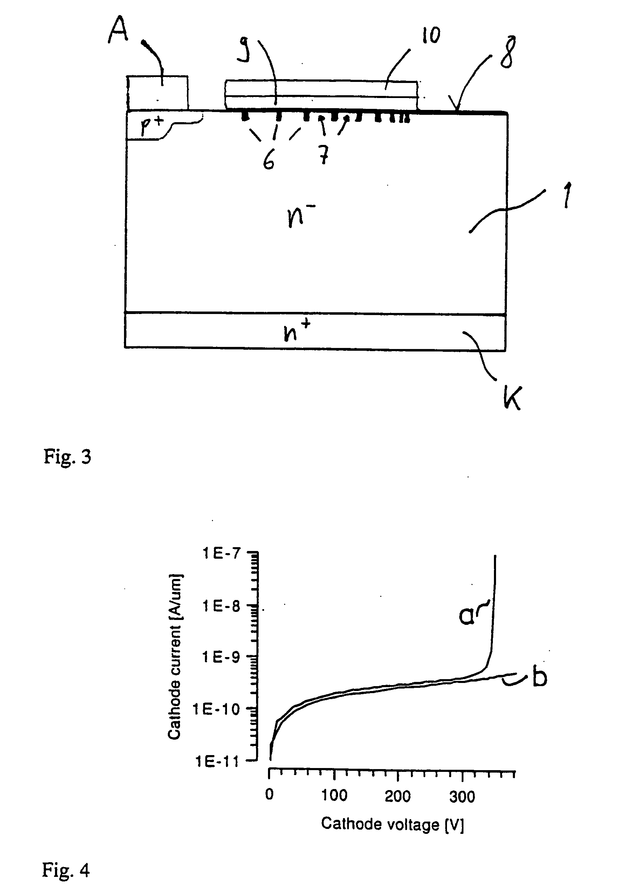

In Fig. 3 ist eine weitere erfindungsgemäße Lösung der Aufgabe anhand einer vertikalen Diode dargestellt. Das dargestellte Bauelement ist ein vertikales Bauelement, bei dem Anodenanschluß A und Kathodenanschluß K auf entgegengesetzten Oberflächen des Halbleiterkörpers 1 angeordnet sind und weist eine Feldreduzierungsstruktur an der Oberfläche auf. Die Feldreduzierungsstruktur ist jedoch auch bei lateralen Bauelementen in vergleichbarer Weise einsetzbar.

Der Halbleiterkörper 1 in Fig. 3 weist unterhalb des Anodenanschlusses A einen p⁺-dotierten Bereich in einem n⁻-dotierten Gebiet des Halbleiterkörpers. Zum Kathodenanschluß K hin ist der Halbleiterkörper 1 n⁺-dotiert. Eine laterale Struktur mit Vertiefungen 6 im Halbleiterkörper 1 und Zwischenräumen 7 des Halbleitergebiets 1 zwischen den Vertiefungen 6 ist an der Oberfläche 8 des Halbleiterkörpers 1 angeordnet. Der Übersichtlichkeit wegen sind nur einige der Vertiefungen 6 und nur einige der Zwischenräume 7 mit Bezugszeichen versehen. Die laterale Struktur 6, 7 bildet eine Feldreduktionsstruktur im Wirkungsbereich einer Raumladungszone im Halbleiterkörper 1 und ist dazu vorgesehen, die Feldstärke an der Oberfläche 8 zu reduzieren. Sie kann benachbart zu einem Hauptelektrodenanschluß in vergleichbarer Weise wie übliche Feldringe, Feldplatten und andere Randstrukturen ausgebildet sein. Vorteilhaft ist, die Zwischenräume 7 als Inseln oder Stege auszubilden, die durch die Vertiefungen 6 getrennt sind. Die Dimensionierung kann in vergleichbarer Weise vorgenommen werden, wie bei den Ausführungen zu lateralen Bauelementen gemäß Fig. 1 beschrieben ist. Als Bezugsgröße für günstige Dimensionierungen wird die dort beschriebene laterale Driftstrekke 2 jedoch ersetzt durch die Ausdehnung der Raumladungszone an der Oberfläche 8 des Bauelements, die die Raumladungszone aufgrund der Dotierungsverhältnisse des Halbleiterkörpers 1 bei maximaler Sperrspannung theoretisch annehmen würde.

Günstig ist, wenn die Breite der Vertiefungen 6 höchstens 20% der Ausdehnung der Raumladungszone an der Oberfläche 8 des Bauelements, die die Raumladungszone aufgrund der Dotierungsverhältnisse des Halbleiterkörpers 1 bei maximaler Sperrspannung theoretisch annehmen würde. Günstig ist, wenn die Breite der Zwischenräume 7 höchsten 30% der Ausdehnung der Raumladungszone an der Oberfläche 8 des Bauelements, die die Raumladungszone aufgrund der Dotierungsverhältnisse des Halbleiterkörpers 1 bei maximaler Sperrspannung theoretisch annehmen würde.

Die Feldreduzierungsstruktur 6, 7 kann jeweils auch nur bereichsweise an der Oberfläche 8 des Halbleiterkörpers 1 angeordnet sein.

In einer weiteren günstigen Ausführung nehmen die Abstände unmittelbar benachbarter Vertiefungen 6, d.h. die Breite der Zwischenräume 7, ausgehend von einem Hauptsperrübergang mit zunehmender Entfernung vom Hauptsperrübergang ab. Die Feldverteilung an der Oberfläche 8 des Halbleiterkörpers wird dadurch besonders günstig beeinflußt.

In einer besonders bevorzugten Ausführung ist die Feldreduzierungsstruktur unterhalb einer Feldplatte 10 angeordnet, die von der Oberfläche 8 des Halbleiterkörpers 1 durch eine Oxidschicht 9 getrennt ist. Wie bei der angrenzend an eine vergrabene dielektrische Zone 5 angeordneten Struktur gemäß Fig. 1 wird bei der Feldreduzierungsstruktur an der Oberfläche 8 die Ausbreitung einer Raumladungszone durch die Breite der jeweiligen Zwischenräume 7 bestimmt, bei denen der Kanalabschnitt abgesaugt ist.

In Fig. 4 ist die Abhängigkeit des Kathodenstroms von der Kathodenspannung für die in Fig. 3 angegebene Struktur im Vergleich zu einer Struktur ohne Vertiefungen 6 und Zwischenräume 7 unterhalb einer Feldplatte 10 angegeben. Während die herkömmliche Bauelementstruktur bereits bei etwa 340 V durchbricht, wird die Sperrspannung bei einem gemäß der Erfindung ausgeführten Bauelement zu höheren Werten verschoben.

Ganz besonders vorteilhaft ist eine Kombination einer Feldreduzierungsstruktur an der Oberfläche eines Halbleiterkörpers gemäß der beschriebenen Art mit einer vergrabenen Struktur gemäß Fig. 1 zur Herstellung eines SO[-Bauelements mit besonders verbesserter Durchbruchspannung.

Ein erfindungsgemäßes Verfahren zur Herstellung eines Bauelements mit einer Feldreduzierungsstruktur besteht darin, daß zumindest bereichsweise in die Oberfläche 8 des Halbleiterkörpers 1 Vertiefungen 6 eingebracht werden, und daß die Vertiefungen 6 mit einem isolierenden oder semiisolierenden Material gefüllt werden, welches hochohmiger als der Halbleiterkörper 1 in den Zwischenräumen 7 zwischen den Vertiefungen 6 ist, oder daß die Oberfläche 8 des Halbleiterkörpers 1 zumindest bereichsweise mit einem Oxid beschichtet wird, und daß in das Oxid Gräben 7 eingebracht und mit Halbleitermaterial gefüllt werden. Anschließend kann eine Feldplatte auf der Struktur abgeschieden werden.

Besonders vorteilhaft ist, wenn die Vertiefungen 6 durch Oxidation mit hochohmigem Material gefüllt werden. Günstig ist, wenn das Aspektverhältnis von Breite und Tiefe der Vertiefungen 6 so gewählt ist, daß die Vertiefungen bei der Oxidation mit dem sich bildenden Oxid zuwachsen. Die Vertiefungen 6 können jedoch auch durch Beschichtung mit hochohmigem Material gefüllt werden. Das hochohmige Material ist ein Dielektrikum, insbesondere ein Oxid, oder auch ein semiisolierendes Material.

Bei den erfindungsgemäß dargestellten Bauelementen lassen sich mit einfacher Technologie herkömmliche Bauelementstrukturen so verbessern, daß Sperrspannungen oberhalb von 1000 V erzielt werden können. Daher lassen sich derartige Bauelemente gemäß der Erfindung vorteilhaft in Treiberschaltungen für leistungselektronische Umrichtersysteme einsetzen, die bei höheren Spannungen bei etwa 380 V betrieben werden.

## Patentansprüche

1. Halbleiter-Bauelement mit einem Halbleiterkörper (1) und auf dessen erster Oberfläche (8) zumindest bereichsweise angeordneten Schichten, wobei an der ersten Oberfläche (8) des Halbleiterkörpers (1) oder an der zweiten, der ersten gegenüberliegenden Oberfläche des Halbleiterkörpers (1) zumindest bereichsweise eine laterale, dreidimensionale Struktur (6,7) angeordnet ist, welche vertikale Vertiefungen (6) im Halbleiterkörper (1) aufweist, die ein dielektrisches oder semiisolierendes Material aufweisen, **dadurch gekennzeichnet, daß** zumindest bereichsweise die Dichte von Vertiefungen (6) in einer gedachten Schnittebene senkrecht durch das Halbleiter-Bauelement verschieden ist.

2. Halbleiter-Bauelement nach Anspruch 1,
**dadurch gekennzeichnet, daß** das Halbleiter-Bauelement ein laterales Bauelement ist mit einer an ein Substrat (4) angrenzenden dielektrischen Zone (5) und zwischen dielektrischer Zone (5) und Halbleiterkörper (1) zumindest unter einem Teilbereich des lateralen Bauelements angeordneter lateraler, dreidimensionaler Struktur (6, 7), die mit der dielektrischen Zone (5) in unmittelbarer Verbindung steht.

3. Halbleiter-Bauelement nach
Anspruch 1, **dadurch gekennzeichnet, daß** die laterale, dreidimensionale Struktur (6, 7) an der ersten oberfläche (8) des Halbleiterkörpers (1) angeordnet ist, und dass die laterale, dreidimensionale Struktur (6,7) Stellen an der ersten Oberfläche (8) des Halbleiterkörpers (1) überdeckt, die eine erhöhte Feldstärke aufweisen.

4. Halbleiter-Bauelement nach
Anspruch 1 oder 3, **dadurch gekennzeichnet, daß** die laterale, dreidimensionale Struktur (6, 7) in einer feldringähnlichen Anordnung an der ersten oberfläche (8) des Halbieiterkörpers (1) angeordnet ist.

5. Halbleiter-Bauelement nach mindestens einem der Ansprüche 1,3 oder 4, **dadurch gekennzeichnet, daß** das Halbleiter-Bauelement an der ersten oberfläche (8) zusätzlich eine Feldreduzierungs-Struktur (9, 10) zum Reduzieren einer Raumladungszonenkrümmung und/oder elektrischer Oberflächenfeldstärke des Bauelements aufweist.

6. Halbleiter-Bauelement nach mindestens einem der Ansprüche 1 oder 3 bis 5, **dadurch gekennzeichnet, daß** die Vertiefungen (6) im Halbleiterkörper (1) eine Breite aufweisen, die höchstens 20% von der Ausdehnung einer Raumladungszone im Halbleiterkörper (1) an der ersten oberfläche (8) beträgt, die die Raumladungszone aufgrund von Dotierungsverhältnissen im Halbleiterkörper (1) bei maximaler Sperrspannung theoretisch annehmen würde.

7. Halbleiter-Bauelement nach mindestens einem der Ansprüche 1 oder 3 bis 6, **dadurch gekennzeichnet, daß** die Breite der Zwischenräume (7) zwischen unmittelbar benachbarter Vertiefungen (6) höchstens 30% von der Ausdehnung einer-Raumladungszone an der ersten oberfläche (8) ist, die die Raumladungszone aufgrund von Dotierungsverhältnissen im Halbleiterkörper (1) bei maximaler Sperrspannung theoretisch annehmen würde.

8. Halbleiter-Bauelement nach mindestens einem der Ansprüche 1 oder 3 bis 7, **dadurch gekennzeichnet, daß** die Abstände zwischen unmittelbar benachbarten Vertiefungen (6) in oberflächennahen Bereichen des Halbleiterkörpers (1) ausgehend von einem Hauptsperrübergang mit zunehmender Entfernung vom Hauptsperrübergang abnehmen.

9. Halbleiter-Bauelement nach mindestens einem der Ansprüche 1 bis 8, **dadurch gekennzeichnet, daß** die dreidimensionale Struktur Inseln (7) aufweist, welche durch vertikale Vertiefungen (6) voneinander getrennt sind.

10. Halbleiter-Bauelement nach mindestens einem der Ansprüche 1 bis 8, **dadurch gekennzeichnet, daß** die dreidimensionale Struktur Stege (7) aufweist, welche durch vertikale Vertiefungen (6) voneinander getrennt sind,

11. Halbleiter-Bauelement nach Anspruch 2 oder nach einem der Ansprüche 9 bis 10, wenn abhängig von Anspruch 2, **dadurch gekennzeichnet, daß** im Halbleiterkörper (1) zumindest bereichsweise lateral ein Halbleiter aus einem weiteren Material angeordnet ist, welcher an die dielektrische Zone (5) angrenzt.

12. Halbleiter-Bauelement nach Anspruch 2,
**dadurch gekennzeichnet, daß** zwischen Substrat (4) und dielektrischer Zone (5) zumindest bereichsweise eine laterale Halbleiterschicht angeordnet ist.

13. Halbleiter-Bauelement nach Anspruch 2,
**dadurch gekennzeichnet, daß** zwischen Substrat (4) und dielektrischer Zone (5) zumindest bereichsweise eine laterale Isolatorschicht angeordnet ist.

14. Halbleiter-Bauelement nach mindestens einem der vorangegangenen Ansprüche, **dadurch gekennzeichnet, daß** bei einem lateralen Bauelement zumindest bereichsweise die Breite der Vertiefungen (6) in einer gedachten Schnittebene senkrecht durch das laterale Bauelement kleiner als 10% der lateralen Driftstrecke (2) des lateralen Bauelements ist.

15. Halbleiter-Bauelement nach mindestens einem der vorangegangenen Ansprüche, **dadurch gekennzeichnet, daß** bei einem lateralen Bauelement zumindest bereichsweise die Breite der Zwischenräume (7) zwischen benachbarten Vertiefungen (6) in einer gedachten Schnittebene senkrecht durch das laterale Bauelement in etwa kleiner als 30% der lateralen Driftstrecke (2) ist.

16. Halbleiter-Bauelement nach mindestens einem der vorangegangenen Ansprüche, **dadurch gekennzeichnet, daß** zumindest bereichsweise die Tiefe der Vertiefungen (6) größer ist als deren Breite.

17. Halbleiter-Bauelement nach mindestens einem der vorangegangenen Ansprüche, **dadurch gekennzeichnet, daß** zumindest bereichsweise das Verhältnis von Breite der Vertiefungen (6) und Dicke der dielektrischen Zone (5) kleiner als 1 ist.

18. Halbleiter-Bauelement nach mindestens einem der vorangegangenen Ansprüche, **dadurch gekennzeichnet, daß** zumindest bereichsweise die Breite der Vertiefungen (6) geringer ist die Breite der Zwischenräume (7) zwischen zwei unmittelbar benachbarten Vertiefungen (6).

19. Halbleiter-Bauelement nach mindestens einem der vorangegangenen Ansprüche, **dadurch gekennzeichnet, daß** die Vertiefungen (6) ein Dielektrikum aufweisen.

20. Halbleiter-Bauelement nach mindestens einem der Ansprüche 1 bis 18, **dadurch gekennzeichnet, daß** die Vertiefungen (6) ein semiisolierendes Material aufweisen.

21. Halbleiter-Bauelement nach mindestens einem der vorangegangenen Ansprüche, **dadurch gekennzeichnet, daß** das Bauelement vom IGBT-Typ oder vom Thyristor-Typ ist.

22. Halbleiter-Bauelement nach mindestens einem der Ansprüche 1 bis 20, **dadurch gekennzeichnet, daß** das Halbleiter-Bauelement eine Diode ist.

23. Verfahren zur Herstellung eines lateralen Bauelements mit einem Halbleiterkörper (1) und einem Substrat, mit auf dem Halbleiterkörper zumindest bereichsweise angeordneten Schichten, mit einer an einer Oberfläche des Halbleiterkörpers (1) zumindest bereichsweise angeordneten lateralen, dreidimensionalen Struktur (6,7), welche vertikale Vertiefungen (6) im Halbleiterkörper (1) aufweist, deren Dichte zumindest bereichsweise in einer gedachten Schnittebene senkrecht durch das Halbleiter-Bauelement verschieden ist, wobei an einer Oberfläche des Halbleiterkörpers (1), welche dem lateralen Bauelement gegenüberliegt, zumindest bereichsweise Vertiefungen (6) geätzt werden, die Vertiefungen anschließen mit einem dielektrischen oder semiisolierenden Material gefüllt werden und mit einer Lage eines dielektrischen Materials überdeckt werden, und die überdeckende Lage zumindest mittelbar mit einem Substrat (4) verbunden wird, oder wobei eine zur Verbindung mit dem Halbleiterkörper (1) vorgesehene Oberfläche eines Substrats (4) mit einem Oxid versehen wird, zumindest bereichsweise Vertiefungen in das Oxid eingebracht werden, die Vertiefungen (6) mit einem Halbleitermaterial gefüllt werden, die gefüllten Vertiefungen (6) mit einer Lage aus einem Halbleitermaterial überdeckt werden, und die überdeckende Lage mit dem Halbleiterkörper (1) zumindest mittelbar verbunden wird.

24. Verfahren nach Anspruch 23,
**dadurch gekennzeichnet, daß** die überdeckende Lage vor der Verbindung mit dem Substrat (4) oder dem Halbleiterkörper (1) planarisiert wird.

25. Verfahren nach Anspruch 23 oder 24,
**dadurch gekennzeichnet, daß** die Vertiefungen (6) mit demselben Material gefüllt und überdeckt werden.

26. Verfahren nach Anspruch 23 oder 24,
**dadurch gekennzeichnet, daß** die Vertiefungen (6) mit unterschiedlichem Material gefüllt und überdeckt werden.

27. Verfahren nach Anspruch 23,
**dadurch gekennzeichnet, daß** zum Füllen und zum Überdecken der Vertiefungen (6) unterschiedliches dielektrisches Material oder unterschiedliches semiisolierendes Material oder unterschiedliches Halbleitermaterial verwendet wird.

28. Verfahren nach mindestens einem der Ansprüche 23 bis 27, **dadurch gekennzeichnet, daß** das Substrat (4) vor dem Verbinden mit der überdeckenden Lage oxidiert wird oder mit einem Oxid beschichtet wird.

29. Verfahren nach mindestens einem der Ansprüche 23 bis 28, **dadurch gekennzeichnet, daß** die überdeckende Lage vor dem Verbinden mit dem Substrat (4) mit einem Halbleiter beschichtet wird.

30. Verfahren nach mindestens einem der Ansprüche 23 bis 29, **dadurch gekennzeichnet, daß** zwischen Halbleiterkörper (1) und überdeckender Lage ein zusätzliches Halbleitermaterial angeordnet wird.

31. Verfahren zur Herstellung eines lateralen Bauelements mit einem Halbleiterkörper (1), mit einem Substrat und mit auf der ersten Oberfläche (8) des Halbleiterkörpers (1) zumindest bereichsweise angeordneten Schichten, mit einer an der ersten Oberfläche (8) des Halbleiterkörpers (1) zumindest bereichsweise angeordneten lateralen, dreidimensionalen Struktur (6,7), welche vertikale Vertiefungen (6) im Halbleiterkörper (1) aufweist, deren Dichte zumindest bereichsweise in einer gedachten Schnittebene senkrecht durch das Halbleiter-Bauelement verschieden ist, wobei zumindest bereichsweise in die erste Oberfläche (8) des Halbleiterkörper (1) Vertiefungen (6) eingebracht werden, und die Vertiefungen (6) mit einem dielektrischen oder semiisolierenden Material gefüllt werden, oder wobei die erste Oberfläche (8) des Halbleiterkörpers (1) zumindest bereichsweise mit einem Oxid beschichtet wird, und in das Oxid Gräben (7) eingebracht und mit Halbleitermaterial gefüllt werden.

32. Verfahren nach Anspruch 31,
**dadurch gekennzeichnet, daß** die Vertiefungen (6) durch Oxidation mit hochohmigem Material gefüllt werden.

33. Verfahren nach Anspruch 31 oder 32,
**dadurch gekennzeichnet, daß** die Vertiefungen (6) durch Beschichtung mit hochohmigem Material gefüllt werden.

34. Verfahren nach Anspruch 31, 32 oder 33,
**dadurch gekennzeichnet, daß** zumindest bereichsweise auf die Vertiefungen (6) eine feldplattenartige Struktur abgeschieden wird.

35. Verwendung eines Bauelements mit lateraler dreidimensionaler Struktur nach mindestens einem der Ansprüche 1 bis 22 in einer Treiberschaltung für leistungselektronische Umrichtersysteme.

## Claims

1. A semiconductor component comprising a semiconductor body (1) an layers arrange at least region-wise on the first surface (8) thereof, wherein arranged at the first surface (8) of the semiconductor body (1) or at the second surface opposite to the first of the semiconductor body (1) at least region-wise is a lateral three-dimensional structure (6, 7) having vertical recesses (6) in the semiconductor body (1), which have a dielectric or semi-insulating material, **characterised in that** the density of recesses (6) is different at least region-wise in a notional sectional plane perpendicularly through the semiconductor component.

2. A semiconductor component according to claim 1 **characterised in that** the semiconductor component is a lateral component with a dielectric zone (5) adjoining a substrate (4) and a lateral three-dimensional structure (6, 7) which is arranged at least under a portion of the lateral component between the dielectric zone (5) and the semiconductor body (1) and which is directly connected to the dielectric zone (5).

3. A semiconductor component according to claim 1 **characterised in that** the lateral three-dimensional structure (6, 7) is arranged at the first surface (8) of the semiconductor body (1) and the lateral three-dimensional structure (6, 7) covers over locations at the first surface (8) of the semiconductor body (1), which have an increased field strength.

4. A semiconductor component according to claim 1 or claim 3 **characterised in that** the lateral three-dimensional structure (6, 7) is arranged in a field ring-like arrangement at the first surface (8) of the semiconductor body (1).

5. A semiconductor component according to at least one of claims 1, 3 and 4 **characterised in that** at the first surface (8) the semiconductor component additionally has a field-reducing structure (9, 10) for reducing a space charge zone curvature and/or electric surface field strength of the component.

6. A semiconductor component according to at least one of claims 1 and 3 to 5 **characterised in that** the recesses (6) in the semiconductor body (1) are of a width which is at most 20% of the extent of a space charge zone in the semiconductor body (1) at the first surface (8), that the space charge zone would theoretically assume by virtue of doping conditions in the semiconductor body (1) at maximum reverse voltage.

7. A semiconductor component according to at least one of claims 1 and 3 to 6 **characterised in that** the width of the intermediate spaces (7) between directly adjacent recesses (6) is at most 30% of the extent of a space charge zone at the first surface (8), that the space charge zone would theoretically assume by virtue of doping conditions in the semiconductor body (1) at maximum reverse voltage.

8. A semiconductor component according to at least one of claims 1 and 3 to 7 **characterised in that** the spacings between directly adjacent recesses (6) in regions of the semiconductor body (1), that are near the surface, decrease starting from a main reverse junction with increasing distance from the main reverse junction.

9. A semiconductor component according to at least one of claims 1 to 8 **characterised in that** the three-dimensional structure has islands (7) separated from each other by vertical recesses (6).

10. A semiconductor component according to at least one of claims 1 to 8 **characterised in that** the three-dimensional structure has lands (7) separated from each other by vertical recesses (6).

11. A semiconductor component according to claim 2 or according to one of claims 9 and 10 when appendant to claim 2 **characterised in that** arranged in the semiconductor body (1) in at least region-wise lateral relationship is a semiconductor of a further material which adjoins the dielectric zone (5).

12. A semiconductor component according to claim 2 **characterised in that** a lateral semiconductor layer is arranged at least region-wise between substrate (4) and dielectric zone (5).

13. A semiconductor component according to claim 2 **characterised in that** a lateral insulator layer is arranged at least region-wise between substrate (4) and dielectric zone (5).

14. A semiconductor component according to at least one of the preceding claims **characterised in that** in a lateral component the width of the recesses (6) in a notional sectional plane perpendicularly through the lateral component is at least region-wise less than 10% of the lateral drift distance (2) of the lateral component.

15. A semiconductor component according to at least one of the preceding claims **characterised in that** in a lateral component the width of the intermediate spaces (7) between adjacent recesses (6) in a notional sectional plane perpendicularly through the lateral component is at least region-wise approximately less than 30% of the lateral drift distance (2).

16. A semiconductor component according to at least one of the preceding claims **characterised in that** the depth of the recesses (6) is at least region-wise greater than their width.

17. A semiconductor component according to at least one of the preceding claims **characterised in that** the ratio of the width of the recesses (6) and the thickness of the dielectric zone (5) is at least region-wise less than one.

18. A semiconductor component according to at least one of the preceding claims **characterised in that** the width of the recesses (6) is at least region-wise less than the width of the intermediate spaces (7) between two directly adjacent recesses (6).

19. A semiconductor component according to at least one of the preceding claims **characterised in that** the recesses (6) have a dielectric.

20. A semiconductor component according to at least one of claims 1 to 18 **characterised in that** the recesses (6) have a semi-insulating material.

21. A semiconductor component according to at least one of the preceding claims **characterised in that** the component is of IGBT type or of thyristor type.

22. A semiconductor component according to at least one of claims 1 to 20 **characterised in that** the semiconductor component is a diode.

23. A process for the production of a lateral component with a semiconductor body (1) and a substrate, with layers arranged at least region-wise on the semiconductor body, with a lateral three-dimensional structure (6, 7) which is arranged at least region-wise at a surface of the semiconductor body (1) and which has vertical recesses (6) in the semiconductor body (1), the density of which is at least region-wise different in a notional sectional plane perpendicularly through the semiconductor component, wherein recesses (6) are etched at least region-wise at a surface of the semiconductor body (1), which is opposite to the lateral component, the recesses are then filled with a dielectric or semi-insulating material and are covered over with a layer of a dielectric material and the covering layer is at least indirectly connected to a substrate (4), or wherein a surface of a substrate (4), that is provided for connection to the semiconductor body (1), is provided with an oxide, recesses are at least region-wise introduced into the oxide, the recesses (6) are filled with a semiconductor material, the filled recesses (6) are covered over with a layer of a semiconductor material and the covering layer is at least indirectly connected to the semiconductor body (1).

24. A process according to claim 23 **characterised in that** the covering layer is planarised prior to connection to the substrate (4) or the semiconductor body (1).

25. A process according to claim 23 or claim 24 **characterised in that** the recesses (6) are filled and covered over with the same material.

26. A process according to claim 23 or claim 24 **characterised in that** the recesses (6) are filled and covered over with different material.

27. A process according to claim 23 **characterised in that** different dielectric material or different semi-insulating material or different semiconductor material is used for filling and covering over the recesses (6).

28. A process according to at least one of claims 23 to 27 **characterised in that** the substrate (4) is oxidised or coated with an oxide before connection to the covering layer.

29. A process according to at least one of claims 23 to 28 **characterised in that** the covering layer is coated with a semiconductor before connection to the substrate (4).

30. A process according to at least one of claims 23 to 29 **characterised in that** an additional semiconductor material is arranged between the semiconductor body (1) and the covering layer.

31. A process for the production of a lateral component with a semiconductor body (1), with a substrate and with layers arranged at least region-wise on the first surface (8) of the semiconductor body (1), with a lateral three-dimensional structure (6, 7) which is arranged at least region-wise at the first surface (8) of the semiconductor body (1) and which has vertical recesses (6) in the semiconductor body (1), the density of which is different at least region-wise in a notional sectional plane perpendicularly through the semiconductor component, wherein recesses (6) are introduced at least region-wise into the first surface (8) of the semiconductor body (1) and the recesses (6) are filled with a dielectric or semi-insulating material, or wherein the first surface (8) of the semiconductor body (1) is coated at least region-wise with an oxide and trenches (7) are introduced into the oxide and filled with semiconductor material.

32. A process according to claim 31 **characterised in that** the recesses (6) are filled with high-ohmic material by oxidation.

33. A process according to claim 31 or claim 32 **characterised in that** the recesses (6) are filled with high-ohmic material by coating.

34. A process according to claim 31, 32 or 33 **characterised in that** a field plate-like structure is deposited at least region-wise on the recesses (6).

35. Use of a component with a lateral three-dimensional structure according to at least one of claims 1 to 22 in a driver circuit for power-electronic converter systems.

## Revendications

1. Composant à semi-conducteur avec un corps de semi-conducteur (1) et des couches disposées au moins localement sur la première surface (8) de celui-ci, dans lequel une structure latérale tridimensionnelle (6, 7) est disposée au moins localement sur la première surface (8) du corps de semi-conducteur (1) ou sur la deuxième surface du corps de semi-conducteur opposée à la première, structure qui présente dans le corps de semi-conducteur (1) des creux verticaux (6) qui présentent un matériau diélectrique ou semi-isolant, **caractérisé en ce que** la densité de creux (6) est au moins localement différente dans un plan de coupe imaginaire perpendiculaire à travers le composant à semi-conducteur.

2. Composant à semi-conducteur selon la revendication 1, **caractérisé en ce que** le composant à semi-conducteur est un composant latéral avec une zone diélectrique (5) adjacente à un substrat (4) et une structure tridimensionnelle latérale (6, 7) disposée entre la zone diélectrique (5) et le corps de semi-conducteur (1) au moins sous une zone partielle du composant latéral, et qui est en liaison directe avec la zone diélectrique (5).

3. Composant à semi-conducteur selon la revendication 1, **caractérisé en ce que** la structure tridimensionnelle latérale (6, 7) est disposée sur la première surface (8) du corps de semi-conducteur (1), et **en ce que** la structure tridimensionnelle latérale (6, 7) recouvre des endroits de la première surface (8) du corps de semi-conducteur (1) qui présentent une intensité de champ accrue.

4. Composant à semi-conducteur selon la revendication 1 ou 3, **caractérisé en ce que** la structure tridimensionnelle latérale (6, 7) est disposée en un agencement en anneau de champ sur la première surface (8) du corps de semi-conducteur (1).

5. Composant à semi-conducteur selon au moins une des revendications 1, 3 ou 4, **caractérisé en ce que** le composant à semi-conducteur présente en plus, sur la première surface (8), une structure de réduction de champ (9, 10) pour réduire une courbure de la zone de charge d'espace et/ou l'intensité de champ électrique de surface du composant.

6. Composant à semi-conducteur selon au moins une des revendications 1 ou 3 à 5, **caractérisé en ce que** les creux (6) dans le corps de semi-conducteur (1) présentent une largeur qui vaut au maximum 20 % de l'extension d'une zone de charge d'espace dans le corps de semi-conducteur (1) sur la première surface (8), que la zone de charge d'espace occuperait théoriquement en raison des rapports de dopage dans le corps de semi-conducteur (1) pour une tension de blocage maximale.

7. Composant à semi-conducteur selon au moins une des revendications 1 ou 3 à 6, **caractérisé en ce que** la largeur des espaces intermédiaires (7) entre des creux immédiatement voisins (6) vaut au maximum 30 % de l'extension d'une zone de charge d'espace sur la première surface (8), que la zone de charge d'espace occuperait théoriquement en raison des rapports de dopage dans le corps de semi-conducteur (1) pour une tension de blocage maximale.

8. Composant à semi-conducteur selon au moins une des revendications 1 ou 3 à 7, **caractérisé en ce que** les distances entre des creux immédiatement voisins (6) dans des régions du corps de semi-conducteur (1) proches de la surface diminuent à partir d'une transition de blocage principale lorsque la distance à la transition de blocage principale augmente.

9. Composant à semi-conducteur selon au moins une des revendications 1 à 8, **caractérisé en ce que** la structure tridimensionnelle présente des îlots (7), qui sont séparés les uns des autres par des creux verticaux (6).

10. Composant à semi-conducteur selon au moins une des revendications 1 à 8, **caractérisé en ce que** la structure tridimensionnelle présente des nervures (7), qui sont séparées les unes des autres par des creux verticaux (6).

11. Composant à semi-conducteur selon la revendication 2 ou selon l'une quelconque des revendications 9 à 10, lorsqu'elle dépend de la revendication 2, **caractérisé en ce qu'**un semi-conducteur en un autre matériau est disposé latéralement au moins localement dans le corps de semi-conducteur (1) et est adjacent à la zone diélectrique (5).

12. Composant à semi-conducteur selon la revendication 2, **caractérisé en ce qu'**une couche de semi-conducteur latérale est disposée au moins localement entre le substrat (4) et la zone diélectrique (5).

13. Composant à semi-conducteur selon la revendication 2, **caractérisé en ce qu'**une couche isolante latérale est disposée au moins localement entre le substrat (4) et la zone diélectrique (5).

14. Composant à semi-conducteur selon au moins une des revendications précédentes, **caractérisé en ce que**, dans un composant latéral, la largeur des creux (6) dans un plan de coupe imaginaire perpendiculaire à travers le composant latéral est au moins localement inférieure à 10 % de la plage de dérive latérale (2) du composant latéral.

15. Composant à semi-conducteur selon au moins une des revendications précédentes, **caractérisé en ce que**, dans un composant latéral, la largeur des espaces intermédiaires (7) entre des creux immédiatement voisins (6) dans un plan de coupe imaginaire perpendiculaire à travers le composant latéral est au moins localement sensiblement inférieure à 30 % de la plage de dérive latérale (2).

16. Composant à semi-conducteur selon au moins une des revendications précédentes, **caractérisé en ce que** la profondeur des creux (6) est au moins localement plus grande que leur largeur.

17. Composant à semi-conducteur selon au moins une des revendications précédentes, **caractérisé en ce que** le rapport de la largeur des creux (6) à l'épaisseur de la zone diélectrique (5) est au moins localement inférieur à 1.

18. Composant à semi-conducteur selon au moins une des revendications précédentes, **caractérisé en ce que** la largeur des creux (6) est au moins localement plus petite que la largeur des espaces intermédiaires (7) entre deux creux immédiatement voisins (6).

19. Composant à semi-conducteur selon au moins une des revendications précédentes, **caractérisé en ce que** les creux (6) présentent un diélectrique.

20. Composant à semi-conducteur selon au moins une des revendications précédentes, **caractérisé en ce que** les creux (6) présentent un matériau semi-isolant.

21. Composant à semi-conducteur selon au moins une des revendications précédentes, **caractérisé en ce que** le composant est du type IGBT ou du type thyristor.

22. Composant à semi-conducteur selon au moins une des revendications 1 à 20, **caractérisé en ce que** le composant à semi-conducteur est une diode.

23. Procédé de fabrication d'un composant latéral avec un corps de semi-conducteur (1) et un substrat, avec des couches disposées au moins localement sur le corps de semi-conducteur, avec une structure tridimensionnelle latérale (6, 7) disposée au moins localement sur une surface du corps de semi-conducteur (1), qui présente dans le corps de semi-conducteur (1) des creux verticaux (6) dont la densité est différente au moins localement dans un plan de coupe imaginaire perpendiculaire à travers le composant à semi-conducteur, dans lequel des creux (6) sont gravés au moins localement sur une surface du corps de semi-conducteur (1) qui est opposée au composant latéral, les creux sont ensuite comblés avec un matériau diélectrique ou semi-isolant et sont recouverts avec une couche d'un matériau diélectrique, et la couche de recouvrement est reliée au moins indirectement à un substrat (4), ou dans lequel une surface d'un substrat (4) prévue pour la liaison avec le corps de semi-conducteur (1) est pourvue d'un oxyde, des creux sont pratiqués au moins localement dans l'oxyde, les creux (6) sont comblés avec un matériau semi-conducteur, les creux comblés (6) sont recouverts avec une couche d'un matériau semi-conducteur, et la couche de recouvrement est reliée au moins indirectement au corps de semi-conducteur (1).

24. Procédé selon la revendication 23, **caractérisé en ce que** l'on aplanit la couche de recouvrement avant la liaison avec le substrat (4) ou le corps de semi-conducteur (1).

25. Procédé selon la revendication 23 ou 24, **caractérisé en ce que** l'on comble et on l'on recouvre les creux (6) avec le même matériau.

26. Procédé selon la revendication 23 ou 24, **caractérisé en ce que** l'on comble et l'on recouvre les creux (6) avec un matériau différent.

27. Procédé selon la revendication 23, **caractérisé en ce que** l'on utilise, pour le comblement et le recouvrement des creux (6), un matériau diélectrique différent ou un matériau semi-isolant différent ou un matériau semi-conducteur différent.

28. Procédé selon au moins une des revendications 23 à 27, **caractérisé en ce que** l'on oxyde le substrat (4) ou on le revêt d'oxyde avant la liaison avec la couche de recouvrement.

29. Procédé selon au moins une des revendications 23 à 28, **caractérisé en ce que** l'on revêt la couche de recouvrement avec un semi-conducteur avant la liaison avec le substrat (4).

30. Procédé selon au moins une des revendications 23 à 29, **caractérisé en ce que** l'on dispose un matériau semi-conducteur supplémentaire entre le corps de semi-conducteur (1) et la couche de recouvrement.

31. Procédé de fabrication d'un composant latéral avec un corps de semi-conducteur (1), avec un substrat et avec des couches disposées au moins localement sur la première surface (8) du corps de semi-conducteur (1), avec une structure tridimensionnelle latérale (6, 7) disposée au moins localement sur la première surface (8) du corps de semi-conducteur (1), qui présente dans le corps de semi-conducteur (1) des creux verticaux (6) dont la densité est différente au moins localement dans un plan de coupe imaginaire perpendiculaire à travers le composant à semi-conducteur, dans lequel des creux (6) sont pratiqués au moins localement dans la première surface (8) du corps de semi-conducteur (1) et les creux sont comblés avec un matériau diélectrique ou semi-isolant, ou dans lequel la première surface (8) du corps de semi-conducteur (1) est au moins localement revêtue d'un oxyde, et des fosses (7) sont pratiquées dans l'oxyde et sont comblées avec un matériau semi-conducteur.

32. Procédé selon la revendication 31, **caractérisé en ce que** l'on comble les creux (6) par oxydation avec un matériau à haute résistance électrique.

33. Procédé selon la revendication 31 ou 32, **caractérisé en ce que** l'on comble les creux (6) par revêtement avec un matériau à haute résistance électrique.

34. Procédé selon la revendication 31, 32 ou 33, **caractérisé en ce que** l'on dépose au moins localement une structure de type magnétorésistance sur les creux (6).

35. Utilisation d'un composant avec une structure tridimensionnelle latérale selon au moins une des revendications 1 à 22 dans un circuit d'excitation pour des systèmes de mutateurs électroniques de puissance.
